# EUROPEAN PATENT APPLICATION

(11) **EP 1 458 069 A1**
(43) Date of publication of application: **15.09.2004**
(21) Application number: 03251493.7
(22) Date of filing: 12.03.2003
(51) Int. Cl.: H01S 5/0625

(54) **Widely tunable DBR laser source**

(71) Applicant: Agilent Technologies, Inc. - a Delaware corporation -, Palo Alto, CA 94303-0870 (US)
(72) Inventor: Meliga, Marina, 10148 Torino (IT)
(74) Representative: Coker, David Graeme

(57) **Abstract**

The present invention describes a tuneable laser assembly having a plurality of discrete tunable DBR lasers disposed on a substrate and coupled to waveguides and an amplifier via an optical coupler, all integrally formed on the substrate. The assembly can be tuneable over a quasi-continuous range of wavelengths depending on the peak emission, tuning range, and number of laser used.

## Description

The present invention concerns a tuneable distributed Bragg reflector (DBR) laser source, which is tuneable over a wide wavelength range and suitable for use in wavelength division multiplexed (WDM) systems and fixed wavelength communication systems.

More specifically, the present invention concerns a fully integrated tuneable laser source in which the lasers device, optical coupler, and amplifier are all integrated on a single substrate.

US patent number 5,394,489 discloses a tuneable laser source that comprises several fixed wavelength distributed feedback (DFB) lasers disposed on a substrate. The lasers are linked via waveguides to an optical coupler, such as the Star coupler, followed by an amplifier and a modulator. Each laser is individually activated to emit a single wavelength. Thus, depending on the emission wavelength of each laser, the device is capable of emitting a series of discrete wavelengths.

Some tuning of the DFB laser may be possible by controlling the temperature of the lasers, however this is costly and will not provide a laser source that is capable of selectively emitting light covering a continuous range of wavelengths.

The present invention aims to produce a simple, low cost, fully integrated laser source capable of being tuned over a wide range of continuous wavelengths.

Such a laser source has applications in WDM communications systems where several wavelengths are multiplexed and transmitted down a single fibre.

Furthermore, such a tuneable laser source also has applications in single wavelength communication systems, where it is desirable from a manufacturing point of view, to stock a single laser source, which can be used in a variety of optical modules. Depending on the customer's wavelength requirements, the tuneable laser source can be fitted into the module and the appropriate wavelength selected. This has the advantage of reducing inventory and enabling volume production of a single laser source for many types of optical modules.

The object of the present invention is thus to provide a tunable laser source, which overcomes the drawbacks of the solutions of the prior art considered above.

According to the present invention there is provided a tuneable laser assembly comprising a substrate having formed thereon a plurality of tuneable DRB lasers, a plurality of waveguides coupled to each of said lasers respectively, an optical coupler coupled to said waveguides, and an amplifier coupled to said optical coupler, said lasers having peak emission wavelengths and tuning ranges such that said laser assembly can be tuned over a quasi-continuous predetermined wavelength range.

The waveguides, optical coupler, and amplifier may be all integrally formed on the substrate.

While the principle features and advantages of the present invention have been described above, a greater understanding and appreciation of the invention can be obtained from the following figures and detailed description of the preferred embodiment, in which;
Figure 1 shows a plane view of the principle features of the tuneable laser assembly,
Figure 2a shows a further plane view of the laser assembly,
Figure 2b shows a cross section of the laser assembly along the path labelled A-A in figure 2a,
Figure 3 shows an example the wavelength range covered by the tunable laser assembly according to the present invention, and
Figure 4 shows a further embodiment of the present invention coupled to a modulator and an output fibre.

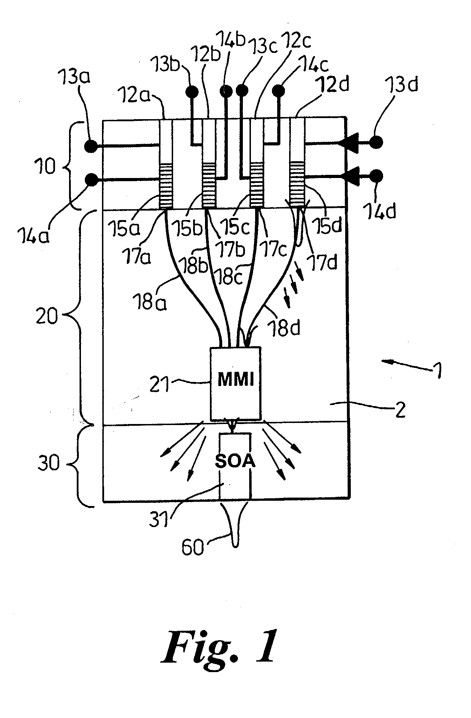

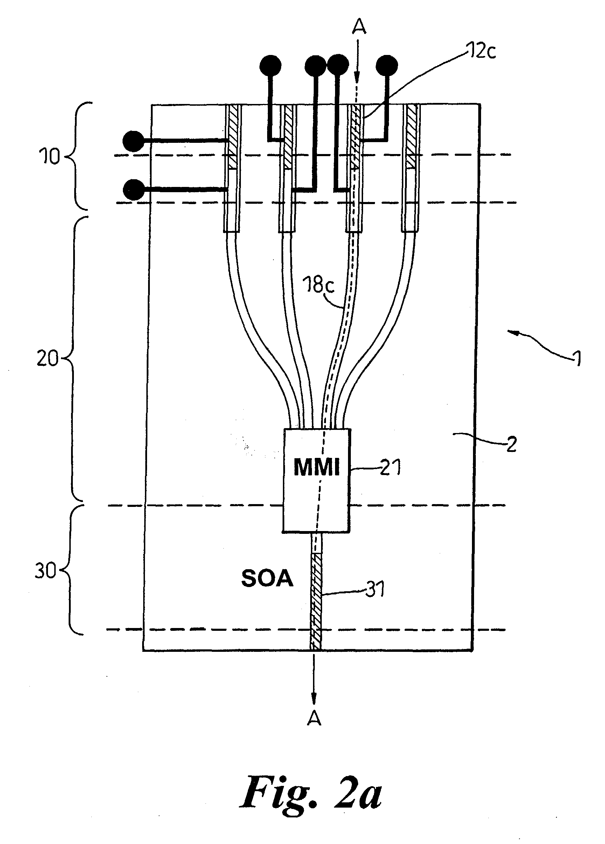

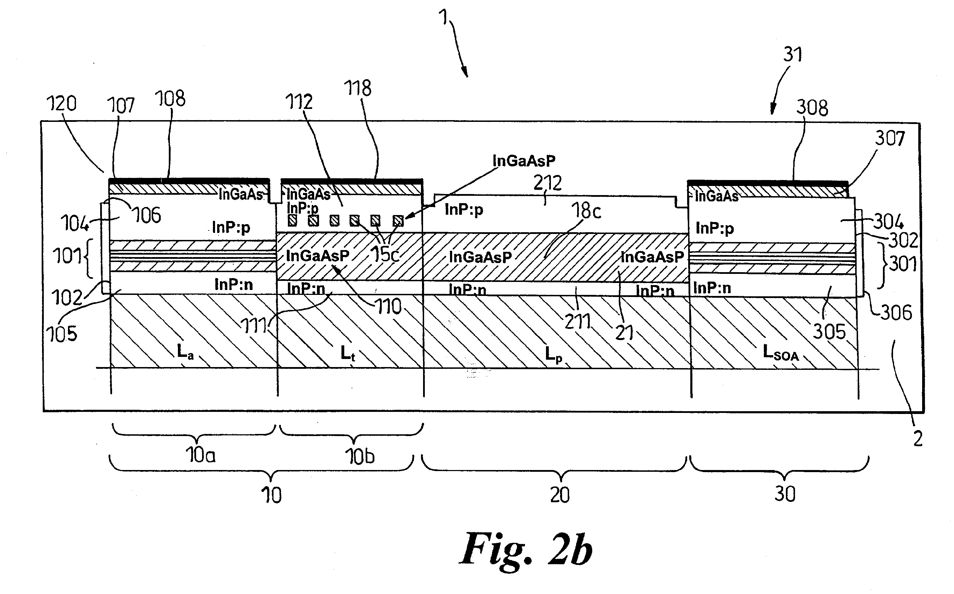

As seen in figures 1, 2a and 2b, the laser assembly 1 can be divided into essentially three sections: the DBR laser 10, the optical coupler 20, and the optical amplifier 30, all of which are integrally formed on a single substrate 2.

The laser section 10 includes a plurality of individual DBR lasers 12a, 12b, 12c, 12d. Each DBR laser is individually activated, by injecting a current (Iₗₐₛₑᵣ) via electrical connections 13a, 13b, 13c and 13d respectively. Each DBR laser includes a grating 15a, 15b, 15c and 15d respectively, which is formed on the surfaces of the laser in a manor well know in the art. The tuning of each laser is achieved by injecting a further current (I_{grating}) to the gratings via further electrical connections 14a, 14b, 14c and 14d respectively. Thus it is possible to both individually activate each DBR laser and to tune each laser.

The laser section 10 has two parts, an active section 10a and a tuning section 10b. The active section comprising of essentially a multiple quantum well layer 101 surrounded by an upper 104 and lower 105 cladding layers. A cap layer 107 is located on top of the upper cladding layer followed by metal contact layer 108. A high reflective coating 106 is deposited on the end face 102 of the laser section.

The tuning section 10b consists of essentially a waveguide layer 110 surrounded by a an upper 112 and lower 111 cladding regions having lower refractive indices than the waveguide layer. A grating structure 15c is formed and surrounded by the upper cladding layer. A metal contact layer 118 is deposited on top of the upper cladding layer.

The operation and tuning of DBR lasers is well known in the art and thus will not be described here in further detail.

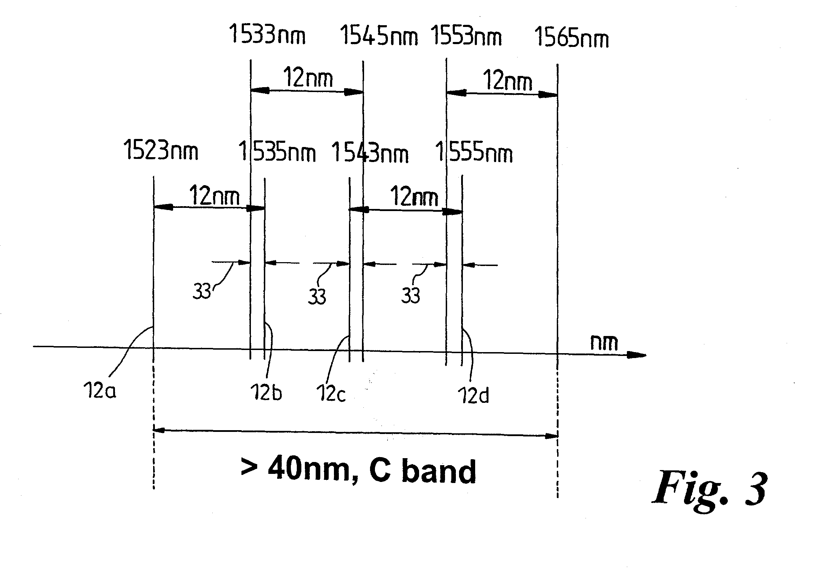

By appropriately selecting the peak emission wavelength of each laser device, it is possible to create a laser source, which is capable of being tuned over a quasi-continuous range of wavelengths. For example, as seen in figure 3, the four DBR laser 12a, 12b, 12c, and 12d are chosen with peak emission wavelengths of 1523nm, 1533nm, 1543nm, and 1553nm respectively, and each laser is was capable of being tuned by + 12nm. The resulting laser source has an effective wavelength range covering over 40nm from 1523nm to 1565nm. This wavelength range more than covers the C band transmission spectrum, which is from 1530nm to 1560nm.

In may be advantageous to select individual DRB lasers with a peak emission wavelengths and tuning ranges so that there is a small overlap 33 with the peak emission wavelength of the next laser.

As will be appreciated, the peak emission wavelength and tuneable range, as well as the number of individual laser devices, can be selected according to the wavelength range required for that particular laser source.

Now turning to section 20 of figure 1, the passive output end 17a, 17b, 17c, 17d of the individual DBR lasers is coupled to a waveguide 18a, 18b, 18c, 18d respectively. The waveguides are formed as an integral part of the substrate 2. Each waveguide is also coupled to an optical coupler 21. The optical coupler can be multimode interference (MMI) coupler, or alternatively, a Star coupler. The optical coupler functions to receive light emitted by the activated laser device and transmitted via its corresponding waveguide and transmit this light to semiconductor optical amplifier (SOA) 31.

As seen in figure 2b, section 20 consists of a waveguide layer 18c surrounded by an upper 212 and lower 211 cladding regions having lower refractive indices than the waveguide layer. The waveguide layer 18c may be the same material as the waveguide layer 110 in section 10b. The multimode interference coupler 21 is formed at the end of section 20 adjacent to section 30.

The SOA is disposed in the third section 30 of the laser assembly and is integrally formed in substrate 2. The SOA comprises of essentially a multiple quantum well layer 301 surrounded by an upper 304 and lower 305 cladding layers. A cap layer 307 is located on top of the upper cladding layer followed by metal contact layer 308. An anti reflective coating 306 is deposited on the end face 302 of the SOA section.

The SOA functions to recover, through amplification, all the optical losses that occur as the light propagated from the laser towards the output 60 of the laser source.

As can be clearly seen in figure 2b, which is a cross section taken along the path labelled A-A in figure 2a, and in which features shown also appearing in figure 1 have the same reference numbers, all the components of the laser assembly are integrally formed on a single substrate 2. This is highly desirable from a manufacturing perspective and enables a compact, low cost tuneable laser source to be made.

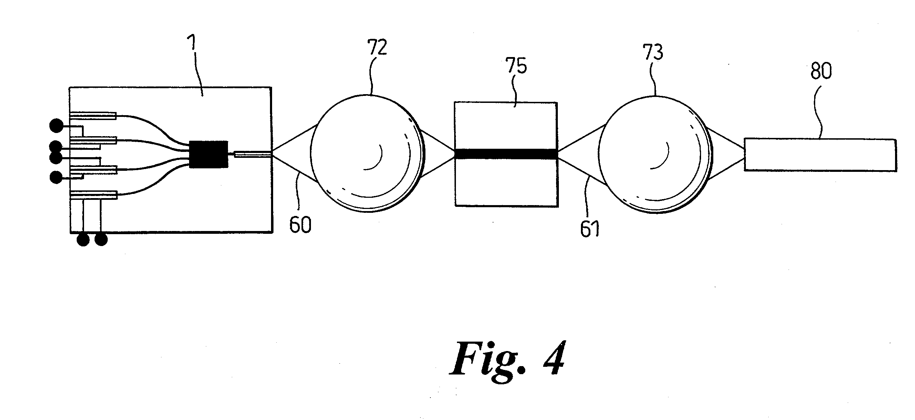

In figure 4 a further embodiment of the present invention is shown in which the output 60 of laser assembly 1 described above is coupled via ball lens 72 to external modulator 75. The output 61 of the modulator is coupled via a second ball lens 73 to output optical fibre 80. The operation of the modulator is well known. The above embodiment demonstrates how the laser assembly of the present invention can be used in a modulated communications network.

It is not intended that the present invention be limited to the above embodiments and other modifications and variations are envisaged within the scope of the claims.

## Claims

1. A tuneable laser assembly comprising:
a substrate (2) having formed thereon a plurality of tuneable DRB lasers (12a, 12b, 12c, 12d),
a plurality of waveguides (18a, 18b, 18c, 18d) coupled to each of said lasers respectively,
an optical coupler (21) coupled to said waveguides, and
an amplifier (31) coupled to said optical coupler,
said lasers having peak emission wavelengths and tuning ranges such that said laser assembly can be tuned over a quasi-continuous predetermined wavelength range.

2. A laser assembly as claimed in Claim 1, wherein said lasers, waveguides, optical coupler, and amplifier are all integrally formed on said substrate.

3. A laser assembly as claimed in Claim 2, wherein said amplifier has sufficient gain so to enable said assembly to output light of substantially the same intensity as output by any one of said lasers.

4. A laser assembly as claimed in any preceding Claim, wherein said optical coupler is a multimode interference coupler.

5. A laser assembly as claimed in any preceding claim, wherein said plurality of lasers have peak emission wavelengths and are sufficiently tunable so as to enable said assembly to emit any wavelength selected from said predetermined quasi-continuous wavelength range.

6. A laser assembly as claimed in Claim 5, wherein said predetermined quasi-continuous wavelength range is covers the C transmission band.

7. A laser assembly as claimed in Claims 5 or 6, wherein said predetermined quasi-continuous wavelength range is from approximately 1523nm to 1565nm.

8. A laser assembly as claimed in any preceding Claim, wherein said assembly comprises four lasers.

9. A laser assembly as claimed in Claim 8, wherein said four lasers (12a, 12b, 12c, 12d) have peak emission wavelengths at 1523nm, 1533nm, 1543nm and 1553nm respectively.

10. A laser assembly as claimed in Claim 9, wherein said lasers can be tuned +12nm.

11. A laser assembly as claimed in any preceding Claim, wherein said lasers are tuned by applying a current to a grating (15a, 15b, 15c, 15d) formed thereon.
